(19) Europäisches Patentamt / European Patent Office / Office européen des brevets

(11) **EP 1 947 682 B1**

(12) **EUROPEAN PATENT SPECIFICATION**

(45) Date of publication and mention
of the grant of the patent:
**18.01.2012 Bulletin 2012/03**

(51) Int Cl.:
*H01L 21/027* (2006.01)   *G02B 5/08* (2006.01)
*G03F 7/20* (2006.01)   *G21K 1/06* (2006.01)

(21) Application number: **06811216.8**

(22) Date of filing: **04.10.2006**

(86) International application number:
**PCT/JP2006/319876**

(87) International publication number:
**WO 2007/043414 (19.04.2007 Gazette 2007/16)**

(54) **MULTILAYER REFLECTING MIRROR, MULTILAYER REFLECTING MIRROR MANUFACTURING METHOD, OPTICAL SYSTEM, EXPOSURE APPARATUS AND DEVICE MANUFACTURING METHOD**

MEHRSCHICHTIGER REFLEKTIERENDER SPIEGEL, VERFAHREN ZUR HERSTELLUNG EINES MEHRSCHICHTIGEN REFLEKTIERENDEN SPIEGELS, OPTISCHES SYSTEM, BELICHTUNGSVORRICHTUNG UND VORRICHTUNGSHERSTELLUNGSVERFAHREN

MIROIR RÉFLECTEUR MULTICOUCHE, PROCÉDÉ DE FABRICATION D'UN MIROIR RÉFLECTEUR MULTICOUCHE, SYSTÈME OPTIQUE, APPAREIL D'EXPOSITION ET PROCÉDÉ DE FABRICATION D'UN DISPOSITIF

(84) Designated Contracting States:
**AT BE BG CH CY CZ DE DK EE ES FI FR GB GR HU IE IS IT LI LT LU LV MC NL PL PT RO SE SI SK TR**

(30) Priority: **11.10.2005 JP 2005295856**

(43) Date of publication of application:
**23.07.2008 Bulletin 2008/30**

(73) Proprietor: **NIKON CORPORATION**
**Chiyoda-ku**
**Tokyo 100-8331 (JP)**

(72) Inventor: **SHIRAISHI, Masayuki**
**Tokyo 100-8331 (JP)**

(74) Representative: **Hooiveld, Arjen Jan Winfried et al**
**Arnold & Siedsma**
**Sweelinckplein 1**
**2517 GK Den Haag (NL)**

(56) References cited:
WO-A2-03/005377    JP-A- 2002 311 198
JP-A- 2002 311 198    JP-A- 2003 066 195
JP-A- 2005 156 201    JP-A- 2006 059 835
US-A1- 2002 084 425    US-A1- 2002 171 922
US-A1- 2003 147 139    US-A1- 2004 061 868
US-A1- 2004 256 047    US-A1- 2005 109 278

• EVA MAJKOVA ET AL: "Figure Error Correction by Reflection Wavefront Control of Cu K[alpha] Grazing Incidence Multilayer Mirrors" OPTICAL REVIEW, SPRINGER, BERLIN, DE, vol. 10, no. 5, 1 September 2003 (2003-09-01), pages 398-401, XP019353129 ISSN: 1349-9432

**Description**

TECHNICAL FIELD

The present invention relates to a multilayer-film reflective mirror, a method of manufacturing the same, an optical system, an exposure system comprising the same, and a method of manufacturing a microdevice comprising the same.

BACKGROUND ART

In recent years, with advances in miniaturization of semiconductor integrated circuits, projection-exposure systems have been developed that use, instead of the ultraviolet (UV) light utilized by older projection-exposure systems, extreme ultraviolet ("EUV") light. EUV light has substantially shorter wavelengths (for example, approximately 11 to 14 nm) than the UV light used previously. The shorter wavelength of EUV light improves the resolving power of optical systems that had reached their diffraction limits with respect to UV light. See Japan Laid-open Patent Document No. 2003-14893.

US 2002/0084425 discloses a multilayer-film reflective mirror comprising a mirror substrate, a multilayer film provided on a surface of the mirror substrate having alternatif layers of a first material and a second material, and a copping layer having a substantially uniform thickness

US 2003/0147139 A1 discloses a method for manufacturing a multilayered film reflection mirror, in which a desirable shape precision of a reflective wavefront can be obtained by locally scroping the multilayered film. A Si-containing coating may be deposited a top the reflective surface after the scraping process for oxidation prevention purposes. DISCLOSURE OF INVENTION

In configuring a projection-exposure system using EUV light (such a system is called an "EUV lithography" system, abbreviated "EUVL" system), there are no known materials that both transmit EUV light. Consequently, in an EUVL system, the constituent optical systems must be configured using EUV-reflective mirrors. But, in this wavelength range, the mirrors must be either oblique-incidence mirrors that utilize total reflection due to their refractive index being slightly smaller than 1, or multilayer-film mirrors in which the respective phases of multiple fronts of weakly reflected light at layer interfaces are superposed constructively in the reflected light to obtain high overall reflectance.

A EUV-reflective mirror employed in an EUVL system must be formed with a highly accurate and precise reflective-surface shape (surface "figure") having extremely small figure errors with respect to wavefront aberration of reflected light. However, machining such a mirror is very difficult. Hence, techniques have been developed that are applied after the multilayer film has been formed on the reflective surface and that involve "shaving" away one layer at a time in selected regions of the multilayer-film reflective surface. This layer-shaving effectively corrects aberrations arising even from sub-nanometer figure errors. See International Patent Publication No. 01/41155.

In the case of a multilayer film comprising alternating layers of molybdenum (Mo) and silicon (Si), shaving the multilayer-film surface can result in an easily oxidized Mo layer being exposed to the atmosphere. Consequently, a single layer of Si or other oxidation-preventing substance, a ruthenium (Ru) layer, or other "capping" layer (to prevent oxidation of the exposed Mo layer) is normally applied at least in the shaved regions. The ruthenium (Ru) layer or other "capping" layer may also prevent carbon contamination in the multilayer film.

Because Ru layers are similar in their optical characteristics to Mo layers, depositing a Ru layer as a capping layer on the surface of a shaved multilayer film causes a considerable change in the phase of the reflected wavefront. The magnitude of the change depends upon the amount of film shaved away. The effect arises due to the fact that the Ru capping layer is conventionally formed over the entire surface, including in locations other than regions in which Mo-layer shaving has occurred. The capping layer also changes the reflectance of the shaved regions, causing irregularities in light propagation in the optical system.

In view of the foregoing, objects of the invention are to provide multilayer-film reflective mirrors having a precise reference-surface shape, methods for manufacturing such multilayer-film reflective mirrors, and optical systems, exposure systems comprising such multilayer-film reflective mirrors. These various aspects are described herein.

MEANS FOR SOLVING THE PROBLEM

The invention provides a multilayer-film reflective mirror, a method of manufacturing a multilayer-film reflective mirror, an optical system, an exposure system and a microdevice manufacturing method as defined by the claims.

BRIEF DESCRIPTION OF THE DRAWINGS

FIG. 1 is an elevational sectional view of a portion of the multilayer-film reflective mirror according to the first embodiment.
FIG. 2 is a flowchart depicting steps in a method for manufacturing a multilayer-film reflective mirror according to the first embodiment.
FIG. 3 shows the configuration of a magnetron-sputtering device used in the first embodiment.
FIG. 4 depicts a step of a method for correcting figure errors of a multilayer-film reflective mirror.
FIG. 5 depicts another step of a method for correcting figure errors of a multilayer-film reflective mirror.

FIG. 6 is an elevational section of a portion of a multilayer-film reflective mirror that has been subjected to figure-error correction according to the first embodiment.

FIG. 7 is a graph of reflectance and phase changes exhibited by a multilayer-film reflective mirror that has been subjected to figure-error correction.

FIG. 8 is a flowchart of steps in a method for depositing a Si single-layer film.

FIG. 9 is an elevational section showing the configuration of a multilayer-film reflective mirror according to the comparative example.

FIG. 10 is an elevational section showing the configuration of a multilayer-film reflective mirror according to the comparative example.

FIG. 11 is a graph of reflectance and phase changes exhibited by a multilayer-film reflective mirror according to the comparative example.

FIG. 12 is a graph of reflectance and phase changes exhibited by a multilayer-film reflective mirror according to the first embodiment.

FIG. 13 shows a situation in which thickness errors of the Si single-layer film occurred in a multilayer-film reflective mirror.

FIG. 14 is a graph of exemplary reflectance profiles resulting from thickness errors in a Si single-layer film in a multilayer-film reflective mirror.

FIG. 15 is a graph of exemplary phase changes resulting from thickness errors in a Si single-layer film in a multilayer-film reflective mirror.

FIG. 16 is an elevational section showing a multilayer-film reflective mirror according to a second embodiment.

FIG. 17 is a graph showing exemplary reflectance changes exhibited by the multilayer-film reflective mirror of the second embodiment.

FIG. 18 is a graph showing exemplary phase changes exhibited by the multilayer-film reflective mirror of the second embodiment.

FIG. 19 is a schematic diagram of the configuration of an embodiment of an EUV exposure device of a third embodiment.

FIG. 20 is a flowchart showing a method for manufacturing a semiconductor device, using the EUV exposure device of a third embodiment.

BEST MODE FOR CARRYING OUT THE INVENTION

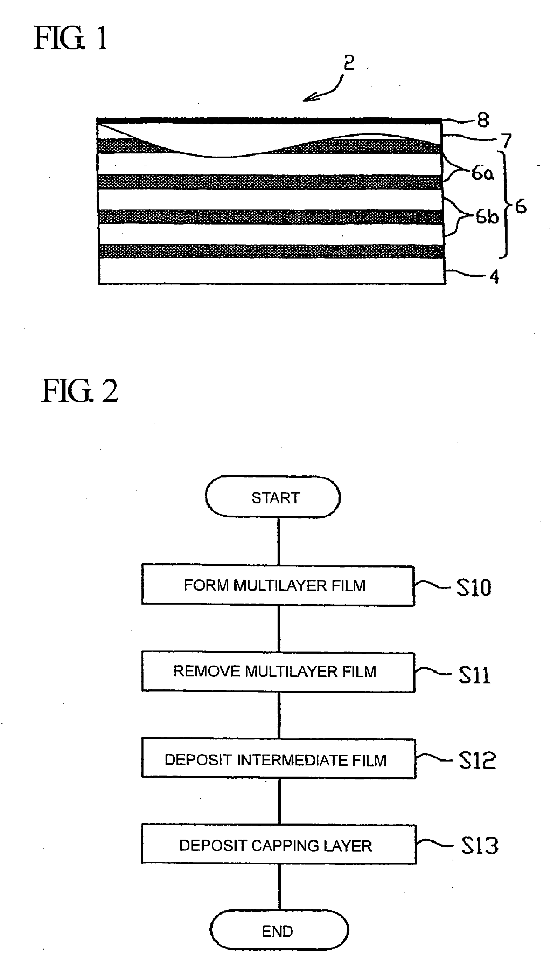

A multilayer-film reflective mirror according to a first embodiment is explained referring to the drawings. The multilayer-film reflective mirror is used, for example, in an EUV exposure device or the like that uses extreme ultraviolet light (EUV light) as the exposure light. FIG. 1 is an elevational section schematically depicting a portion of the multilayer-film reflective mirror 2 of this embodiment. The multilayer-film reflective mirror 2 comprises a multilayer film 6, having a structure in which layers 6a comprising molybdenum (Mo) and layers 6b comprising silicon (Si) are deposited periodically in an alternating manner on the surface of a mirror substrate made of a low-thermal-expansion glass polished to a precise shape (figure profile). The multilayer-film reflective mirror 2 may reflect lights having wavelength of 11 to 14 nm. An intermediate-layer 7, which consists of, or includes Si, is deposited on the multilayer film 6. A capping layer 8, comprising a ruthenium (Ru) layer, is deposited on the intermediate-layer 7 to prevent carbon contamination and oxidation of the intermediate-layer 7. The multilayer film 6 comprises multiple layer-pairs of Mo layers 6a and Si layers 6b. In FIG. 1, however, only four layer-pairs of Mo and Si are shown.

Portions of the surface of the multilayer film 6 are removed ("shaved" or "machined" away) as required so as to impart an in-plane distribution of the amount removed, so as to correct the wavefront of light reflected from the surface. The intermediate-layer 7 has a thickness profile that substantially corresponds to the profile of removed material of the multilayer film 6. The Ru capping layer 8 is deposited uniformly on the intermediate-layer 7, at uniform thickness. The intermediate-layer 7 may include a material or combination of materials chosen from the group of Si, $SiO_2$, SiC, or any combinations of the same. The intermediate-layer 7 may be formed as a multilayer each including different material or combination of materials chosen from the group of Si, $SiO_2$, SiC, or any combinations of the same. The Ru capping layer 8 may include a material or combination of materials chosen from the group of Ru, Ru alloys, rhodium (Rh), Rh alloys, niobium (Nb), Nb alloys, platinum (Pt), Pt alloys, molybdenum (Mo), Mo alloys, $TiO_2$, $SiO_2$, $ZrO_2$, $MoSi_2$, or SiC. Furthermore, the Ru capping layer 8 may be constituted as a multilayer each including a material or combination of materials chosen from the group of Ru, Ru alloys, rhodium (Rh), Rh alloys, niobium (Nb), Nb alloys, platinum (Pt), Pt alloys, molybdenum (Mo), Mo alloys, $TiO_2$, $SiO_2$, $ZrO_2$, $MoSi_2$, or SiC.

In the FIG. 1 embodiment the intermediate-layer 7 is effectively an intermediate layer situated substantially on the surface of the top-most Si layer 6b of the multilayer film 6. Hence, despite the presence of the Ru capping layer 8 in this embodiment, wherein the Ru capping layer is deposited uniformly on the surface of the intermediate-layer 7, phase changes and reflectance changes that otherwise would arise from removal machining are substantially prevented.

Next, a method for manufacturing the first embodiment of the multilayer-film reflective mirror 2 is described, referring to the flowchart of FIG. 2. First, a multilayer film 6, having a structure in which Mo layers 6a (layers of first material) and Si layers 6b (layers of second material) are deposited periodically in an alternating manner, is formed on a low-thermal-expansion glass substrate 4, polished with high precision (step S10). Desirably, a magnetron-sputtering film-deposition device is used to deposit these layers on the reflective surface of the low-thermal-expansion glass substrate 4. Thus formed, the multilayer film 6 has multiple layer-pairs, of which the period length is in the range of 6.9 nm to 7.5 nm.

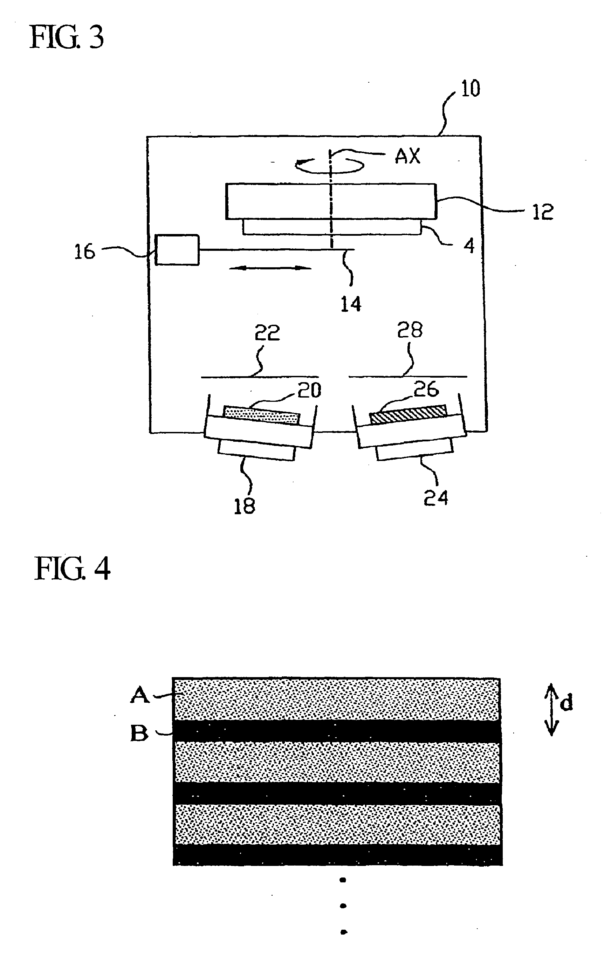

FIG. 3 shows certain features of a magnetron-sputtering film-deposition device that comprises a substrate-holder 12 accommodated within a vacuum chamber 10 evacuated to a suitable vacuum level. The substrate holder 12 holds the low-thermal-expansion glass substrate 4. A rotational driving mechanism (not shown) holds the low-thermal-expansion glass substrate 4 while rotating it about a rotational axis AX.

The magnetron-sputtering film-deposition device further comprises a film-thickness-distribution correction plate 14 that is accommodated within the vacuum chamber 10. The film-thickness-distribution correction plate 14 is positioned in the vicinity of the low-thermal-expansion glass substrate 4 and is configured to move in the directions of the arrow in the drawing by means of a correction-plate-driving mechanism 16. By moving the film-thickness-distribution correction plate 14 in the depicted directions and adjusting the amount of film-deposition particles reaching the low-thermal-expansion glass substrate 4, the thickness of the film deposited on the low-thermal-expansion glass substrate 4 is controlled.

The magnetron-sputtering film-deposition device also includes a first cathode 18, molybdenum (Mo) plate 20 as a first target material, and a first target shutter 22. Process gas is introduced into the vacuum chamber 10, and by applying a voltage to the first cathode 18, a plasma is generated in the vicinity of the Mo plate 20. By means of this plasma, the Mo plate 20 is sputtered, and the sputtered particles of Mo accumulate on the low-thermal-expansion glass substrate 4. The first target shutter 22 is opened during Mo-film deposition, and is closed during Si-film deposition, described below.

The magnetron-sputtering film-deposition device further includes a second cathode 24, a silicon (Si) plate 26 as a second target material, and a second target shutter 28. Process gas is introduced into the vacuum chamber 10, and by applying a voltage to the second cathode 24, a plasma is generated in the vicinity of the Si plate 26. By means of this plasma, the Si plate 26 is sputtered, and the sputtered particles of Si accumulate on the low-thermal-expansion glass substrate 4. The second target shutter 28 is opened during Si-film deposition, and is closed during Mo-film deposition.

Next, the surface of the multilayer film 6 formed in step S10 is removed, imparting an in-plane distribution of the amount of the multilayer film 6 removed (step S11, multilayer film removal step).

Normally, when multiple reflective mirrors are used in a reflecting-optical system of an EUV exposure system, the figure error (FE) allowed in each reflective mirror, with respect to the wavefront error (WFE) of the reflecting-optical system, is given by Equation (1).

$$FE = \frac{WFE}{2\sqrt{n}} \quad (RMS) \quad ... \quad (1)$$

Here, n is the number of reflective mirrors of the optical system. In a reflecting-optical system, both incident light and reflected light are affected by figure error, resulting in wavefront error being proportional to twice the figure error. Hence, Equation (1) includes division by 2. The figure error allowed for each reflective mirror is, for wavelength X and number n of reflective mirrors, given by Equation (2).

$$FE = \frac{\lambda}{28\sqrt{n}} \quad (RMS) \quad ... \quad (2)$$

For example, if the wavelength ($\lambda$) is 13 nm, the figure error allowed for each reflective mirror in a reflecting-optical system comprising four reflective mirrors is 0.23 nm RMS, and the figure error allowed for each reflective mirror in a reflecting-optical system comprising six reflective mirrors is 0.19 nm RMS. When a multilayer-film reflective mirror 2 of the instant embodiment is used in an EUV exposure device, the allowed figure error is similarly calculated. However, it is extremely difficult to manufacture a mirror substrate having a reflective surface with such a highly precise surface figure. Even if the mirror substrate is polished to high precision, subsequent deposition of a multilayer film on it may cause the reflected wavefront to exhibit errors in wavefront shape.

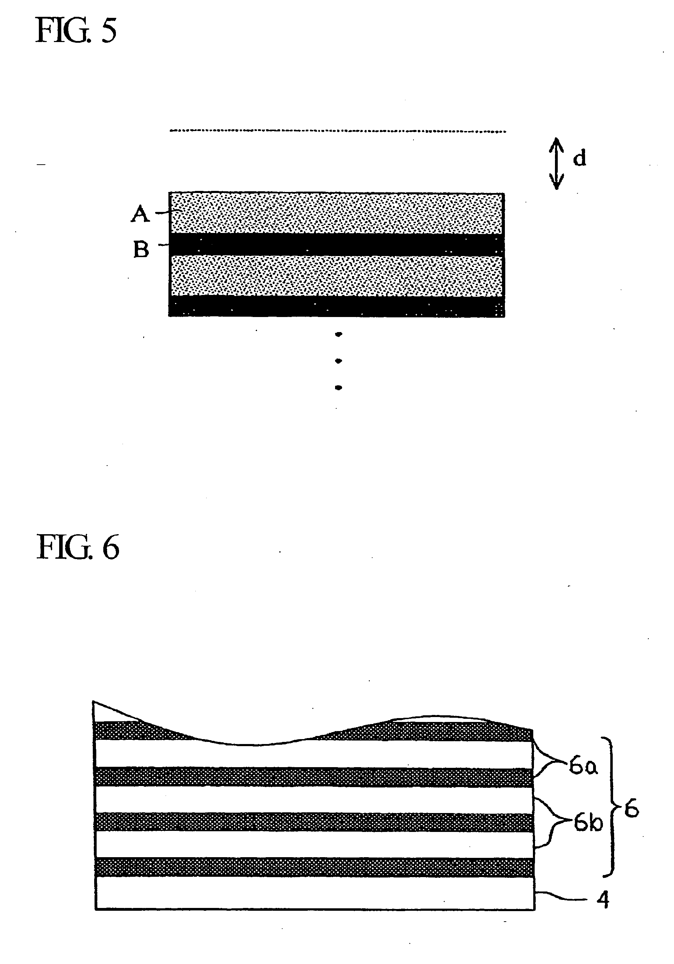

Technology has been developed in which, by shaving off the surface of the multilayer film one layer at a time in selected locations, effective correction of sub-nanometer figure errors is possible (see International Patent Publication no. 01/4115), For example, consider a case in which one layer-pair is locally removed, as shown in FIG 5, from the surface of a multilayer film in which two types of material A and B are layered in an alternating manner with a fixed period length d, as shown in FIG. 4. The optical-path length OP in a layer-pair having thickness d, for a beam propagating in a direction perpendicular to the surface of the multilayer film (FIG. 4), is OP = nAdA + nBdB. Here, dA and dB denote the respective thicknesses of the layers, wherein dA + dB =d. Further, nA and nB are the respective refractive indices of the materials A and B.

In FIG. 5 the optical-path length OP' of the portion of the thickness d removed from the multilayer-film layer-pair in the uppermost surface is given by OP' = nd. Here n is the refractive index of a vacuum, where n = 1. That is, by removing the one or more of the uppermost layers of the multilayer film, the optical-path length traversed by a beam passing therethrough is changed. This is, in effect, optically equivalent to modifying the surface figure by the amount of change of the optical-path length. The change in optical-path length Δ (i.e., the change in surface shape) is given by Δ = OP'-OP.

Because, in the EUV wavelength range, the refractive indices of materials are close to unity, Δ is a small quantity. Thus, by locally shaving off one or more layers as required, layer-by-layer from selected location(s) on the surface of the multilayer-film reflective mirror, the surface shape can be precisely corrected. For example, consider a case in which a Mo/Si multilayer film is used at a wavelength of 13.5 nm. Because the light is substantially directly incident on the mirror surface, it is assumed that the thickness d of a layer-pair is 6.9 nm, that the thickness dMo of each Mo layer is 2.415 nm, and that the thickness dSi of each Si layer is 4.485 nm. The refractive index nMo of Mo at a wavelength of 13.5 nm is 0.92, and the refractive index nSi of Si at this wavelength is 0.998. Using these numbers, the change in optical-path length Δ is calculated. The optical-path length OP, prior to shaving off a layer-pair from a region of the surface of the multilayer-film reflective mirror, is 6.698 nm; the optical-path length OP' after shaving off a layer-pair is 6.9 nm, and the change in optical-path length Δ = OP'- OP = 0.202 nm.

Thus, by locally shaving off a layer-pair, the surface shape is corrected by the equivalent of 0.2 nm. In the case of a Mo/Si multilayer film, because the refractive index of each Si layer to EUV light is close to unity, the change in optical-path length depends mainly on the presence or absence of the Mo layers, and depends hardly at all on the presence or absence of the Si layers. Hence, when removing one or more layers of a multilayer film, there is no need to control the thickness of the Si layers accurately. In the above-described example, the thickness of Si layers is 4.485 nm, and it is sufficient to stop the removal machining midway through the thickness of a Si layer. That is, by performing layer-removal machining with a precision of several nanometers, surface-shape correction can be performed in 0.2-nm increments.

Hence, in step S11 (FIG. 2), first the reflected wavefront of EUV light from the multilayer-film reflective mirror 2, after depositing the multilayer film 6, is measured.

If the measured reflected wavefront has an error with respect to the desired wavefront, the amount of the multilayer film 6 that should be locally machined away to correct the wavefront is determined. Based on the determined amount of removal, removal-machining of the multilayer film 6 is performed in the selected area(s). FIG 6 shows an example configuration of a multilayer-film reflective mirror 2 after local removal-machining of the surface of the multilayer film 6, but before depositing the intermediate-layer 7 and the Ru capping layer 8. The multilayer film 6 comprises multiple layer-pairs each comprising a respective Mo layer 6a and a respective Si layer 6b. In FIG. 6, however, only four layer-pairs of Mo and Si are shown.

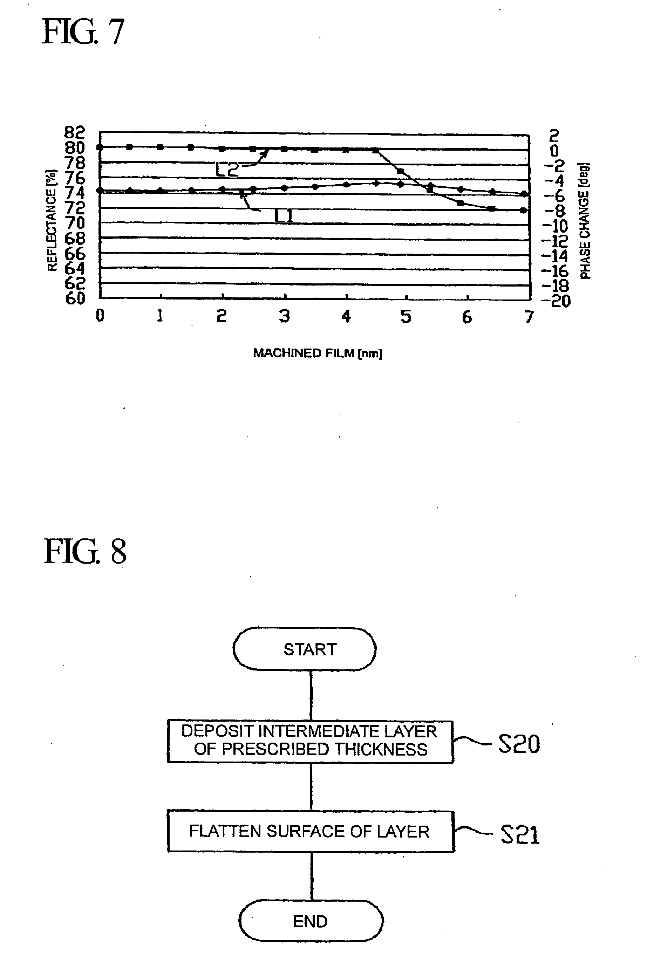

FIG. 7 is a graph of reflectance and phase changes exhibited by the multilayer-film reflective mirror 2, as functions of the depth of layer-removal machining (i.e., the amount of film machined) in step S11. The curve L1 indicates the rate of change of reflectance for EUV light at a wavelength of 13.5 nm, and the curve L2 indicates changes in phase. The change in phase when the machining reaches the depth of the first layer-pair (period length 6.9 nm) of the multilayer film 6 is approximately 8°. The corresponding change in the wavefront for λ = 13.5 nm is 8°/360° × 13.5 nm = 0.30 nm. For comparison, if 6.9 nm of the surface of the mirror substrate had been removed by machining, the change in wavefront would be equal to twice the period length, or 13.8 nm. In the instant embodiment the effect on the wavefront of the amount of film machined on the surface of the multilayer film 6 is 0.30 nm / 13.8 nm = 1 /46.

In the next step (step S12, single-layer film formation step), an intermediate-layer 7 is deposited on the surface of the multilayer film 6 that has been subjected to local layer-removal machining in step S11. The intermediate-layer 7 is formed with a depth (thickness) profile that substantially conforms to the depth profile of material previously removed from the multilayer film 6. The surface of the intermediate-layer 7 is formed to be even. The intermediate-layer 7 functions as an oxidation-prevention film for the Mo layers, thereby preventing oxidation of the Mo layer 6a that has been exposed on the surface as a result of layer-removal machining in step S11.

FIG. 8 is a flowchart depicting an embodiment of a method for depositing the intermediate-layer 7. First, an intermediate-layer 7 of a prescribed thickness is deposited on the surface of a multilayer film 6 which has been subjected to localized layer-removal machining in step S11 of the process in FIG 2 (step S20). That is, an intermediate-layer 7 is deposited uniformly, to a thickness that is equal to or greater than the amount of machined film locally removed, onto the surface of the multilayer film 6.

Next, an amount of the intermediate-layer 7, deposited in step S20, is removed according to the thickness of multilayer film 6 previously removed, i.e., according to the thickness of the multilayer film that had been locally machined away, so that the surface of the intermediate-layer 7 substantially restores the profile of the surface of the multilayer film 6 before the partial removal (step S21). Thus, the amount of the removal of intermediate-layer 7 at one region negatively correlates with the amount of the removal of the multilayer film 6 at the same region.

Next, a Ru capping layer 8 is deposited uniformly at a thickness of approximately 2 nm on the surface of the intermediate-layer 7 deposited in step S12 (step S 13, capping layer film formation step). The Ru capping layer 8 prevents carbon contamination of the multilayer film 6, and prevents oxidation of the multilayer film 6 and of the intermediate-layer 7.

According to the multilayer-film reflective mirror and method of manufacture thereof of the first embodiment, an intermediate-layer having a flat surface is deposited on the surface of a multilayer film previously subjected to localized layer-removal machining. The intermediate-layer has a film thickness corresponding to the amount of the multilayer film previously removed. Hence, even when a Ru capping layer is deposited uniformly on the surface of the intermediate-layer, phase changes and reflectance changes due to the removal machining can be prevented.

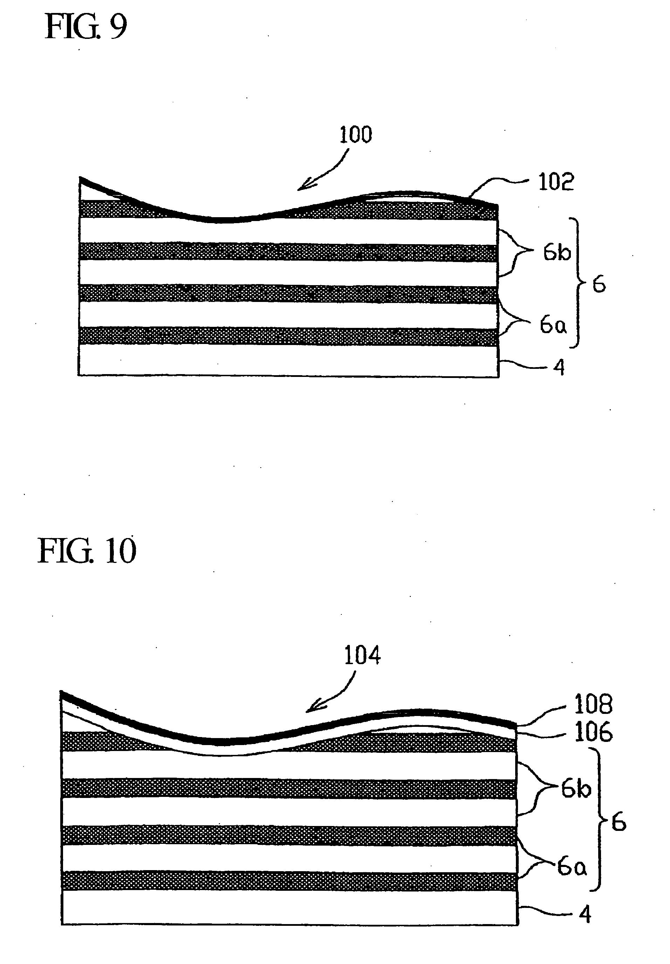

FIGS. 9 and 10 show the configuration of a multilayer-film reflective mirror according to a comparative example. The multilayer-film reflective mirror 100 shown in FIG. 9 includes a Ru capping layer 102 of thickness 2 nm deposited uniformly directly on a multilayer film 6 previously subjected to localized layer-removal machining. In the multilayer-film reflective mirror 104 shown in FIG. 10, a Si single-layer film 106 having a thickness of 2 nm and a Ru capping layer 108 having a thickness of 2 nm are deposited uniformly on the multilayer film 6 previously subjected to localized layer-removal machining. The multilayer film 6 comprises multiple layer-pairs each comprising a respective Mo layer 6a and a respective Si layer 6b. In FIGS. 9 and 10, only four layer-pairs of Mo and Si are shown.

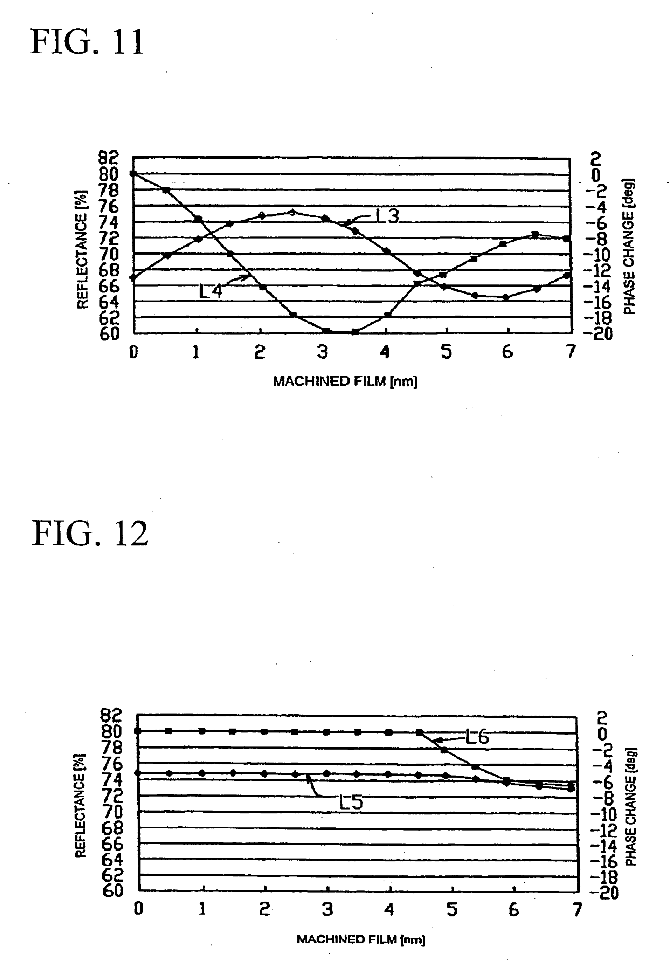

The graph in FIG. 11 shows reflectance and phase change, of the multilayer-film reflective mirrors 100 and 104 shown in FIGS. 9 and 10. The curve L3 is the reflectance of EUV light of wavelength 13.5 nm, and the curve L4 is the phase change. The reflectance and phase change shown in the graph of FIG. 11 fluctuate greatly compared to the reflectance and phase change of a multilayer-film reflective mirror prior to depositing a Ru capping layer 102 or a Si single-layer film 106 and Ru capping layer 108 (see FIG. 7). This fluctuation is due to the fact that the Ru capping layers 102 and 108, which optically are substantially equivalent to the Mo layers 6a of the multilayer film 6, are deposited at positions at which a Mo layer 6a is not meant to be deposited. Hence, despite the fact that the reflected wavefront of the multilayer-film reflective mirror has been corrected by layer-removal machining of the surface of the multilayer film 6, the desired correction of the reflected wavefront is not obtained. Substantial fluctuations in reflectance also may give rise to transmission irregularities.

In contrast, the graph of FIG. 12 shows reflectance and phase change, of the multilayer-film reflective mirror 2 of this embodiment. The curve L5 represents reflectance for EUV light of wavelength 13.5 nm, and the curve L6 represents the phase change. As shown in FIG. 12, there are no large fluctuations in reflectance or phase change such as are seen in the graph of FIG. 11, and the reflectance profile and phase-change profile are substantially the same as the reflectance profile and phase-change profile, respectively, immediately after performing localized layer-removal machining of the multilayer film 6, shown in FIG. 7. In FIG. 12, the change in phase when the film-machining amount reaches one layer-pair (period length 6.9 nm) of the multilayer film 6 is approximately 6.66°. The corresponding change in wavefront is 6.66° /360° × 13.5 nm (wavelength) = 0.25 nm. Normally, if 6.9 nm of the mirror substrate is removed by machining, the change in the wavefront is twice the period length, or 13.8 nm. Thus, the effect on the wavefront of machining the film at the surface of the multilayer film 6 is 0.25 nm / 13.8 nm = 1/55 as great.

That is, in a multilayer-film reflective mirror 2 of this embodiment, an intermediate-layer 7 having an even surface is deposited on the surface of the multilayer film 6 that previously had been subjected to localized layer-removal machining. The intermediate-layer 7 has a thickness profile that corresponds to the depth profile of the layer-machining, so that the Ru capping layer 8 is deposited where a top-most Mo layer 6a otherwise would have been deposited. Further, since no significant reflectance changes or phase changes occur due to the thickness of the newly deposited intermediate-layer 7, high-precision correction of the surface shape can be performed.

In the method for manufacturing a multilayer-film reflective mirror according to the first embodiment, the intermediate-layer 7 of prescribed thickness is deposited on the ) surface of the multilayer film 6 that had previously been subjected to layer-removal machining. The intermediate-layer 7 is then partially removed, so that the top surface is formed to have a surface profile that is substantially the same as the as-designed surface profile of the reflective surface of the mirror. Alternatively, the intermediate-layer 7 can be deposited in such a manner that the surface of the intermediate-layer 7 is at substantially the same level as the surface of the multilayer film 6 had been prior to the layer-removal machining. That is, the intermediate-layer 7 is deposited on the surface of regions from which material of the multilayer film has been removed.

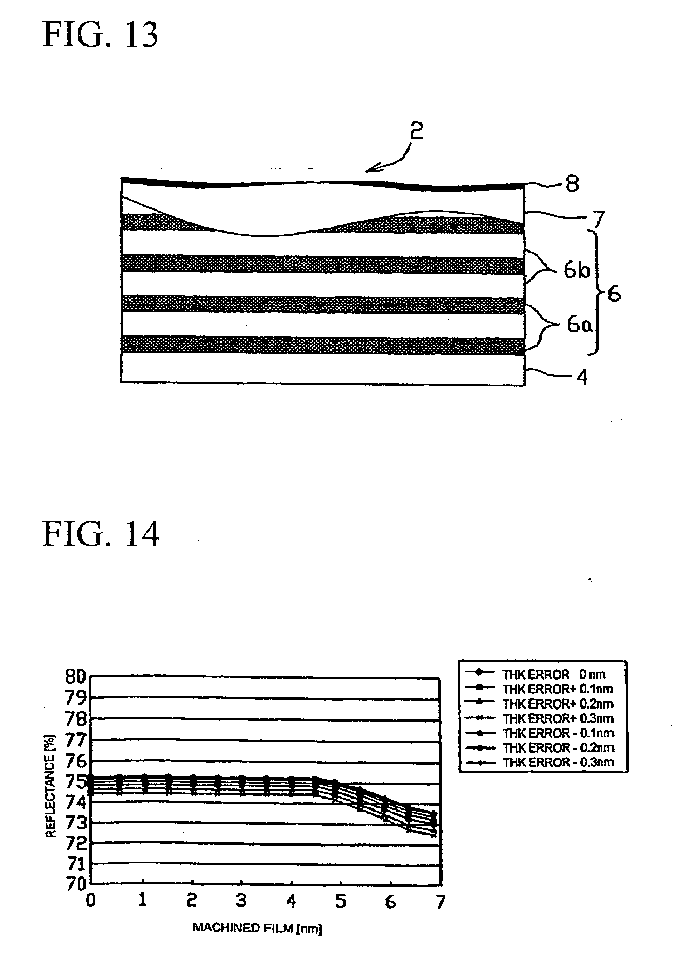

In the first embodiment, the reflected wavefront error is minute even if the intermediate-layer 7 has thickness variations from the ideal surface contour. For example, suppose that, as shown in FIG. 13, the surface of the intermediate-layer 7 does not have the desired contour (e.g., has an error of ± 0.3 nm from the as-designed contour). By depositing the Ru capping layer 8 on the surface of the intermediate-layer 7, the ± 0.3 nm error in the thickness of the intermediate-layer 7 is retained. The multilayer film 6 comprises multiple layer-pairs of Mo layers 6a and Si layers 6b, but in FIG. 13 only four layer-pairs of Mo layers 6a and Si layers 6b are shown.

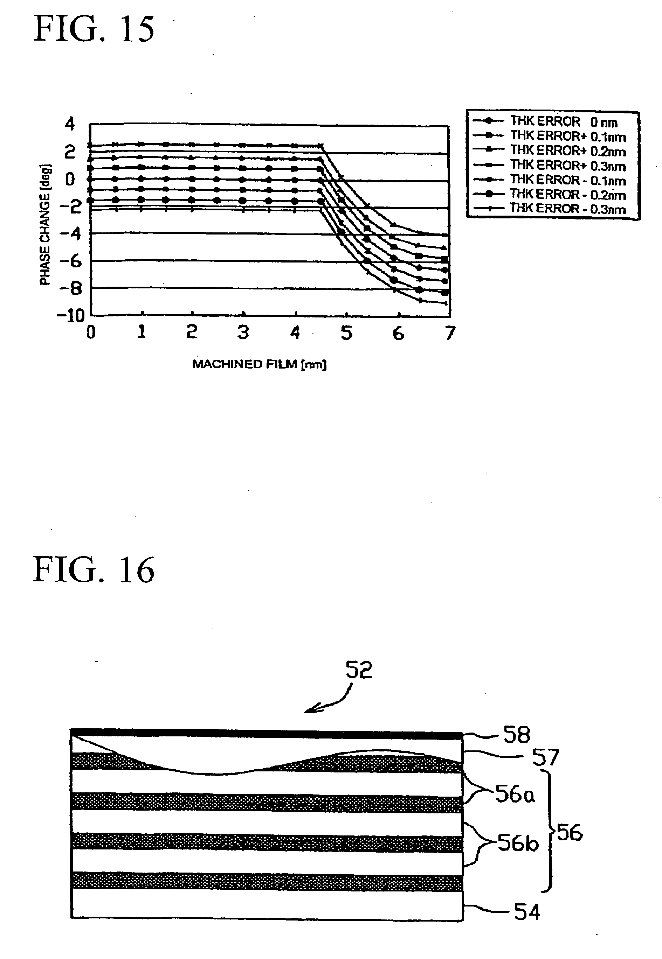

In this case, FIG. 14 is a graph showing changes in reflectance versus the amount of layer-machining performed on the multilayer-film reflective mirror 2 of FIG. 13. FIG. 15 is a graph showing changes in phase versus the amount of layer-machining performed on the multilayer-film reflective mirror 2 of FIG. 13. FIGS. 14 and 15 show changes in reflectance and phase accompanying various thicknesses of the multilayer film machined away. Thickness errors (THK ERROR) of the intermediate-layer 7 of ± 0.3 nm, ± 0.2 nm, and ± 0.1 nm are very small compared to a case in which no thickness error is present (i.e., thickness error = 0 nm).

Phase changes when the thickness error (THK ERROR) of the intermediate-layer 7 is ± 0.3 nm are ± 2.5°, compared to the phase changes when no thickness error is present. The change in the wavefront at this time is ± 2.5°/360° × 13.5 nm = ± 0.09 nm. Normally, with a thickness error of 0.3 nm, the change in the wavefront is twice the thickness error, or 0.6 nm. Therefore, the effect on wavefront of the thickness error in the intermediate-layer 7 is 0.09 nm / 0.6 nm = approximately 1/7.

Next, the multilayer-film reflective mirror of a second embodiment of the invention is explained, referring to the drawings. The multilayer-film reflective mirror of the second embodiment is used in, for example, an EUV exposure system or the like that uses EUV light as the exposure light. FIG. 16 is an elevational section schematically depicting a portion of the multilayer-film reflective mirror 52 of this embodiment. The multilayer-film reflective mirror 52 comprises a multilayer film 56 comprising multiple Mo layers 56a (layers of first material) and Si layers 56b (layers of second material) deposited periodically in an alternating manner on a low-thermal-expansion glass substrate 54 polished to a precise surface profile (shape). The multilayer-film reflective mirror also includes an intermediate-layer 57 which consists of Si or contains Si, deposited as an oxidation-prevention film on the multilayer film 56, which is machined to have a thickness with an in-plane distribution. A capping layer 58, comprising a layer of ruthenium (Ru), is deposited on the intermediate-layer 57 to prevent carbon contamination and oxidation of the intermediate-layer 57. The multilayer film 56 comprises multiple layer-pairs of Mo layers 56a and Si layers 56b, but in FIG. 16 only four layer-pairs of Mo and Si layers are shown.

The multilayer film 56 is formed by depositing multiple layer-pairs of Mo layers 56a and Si layers 56b using the magnetron-sputtering film-deposition device shown in FIG. 3. The multilayer film 56 is formed on the reflective face (surface) of the glass substrate 54, with a period length in the range from 6.9 nm to 7.5 nm.

The surface of the multilayer film 56 is machined, as described above, so as to produce a desired in-plane distribution of the removed amount that serves to correct the reflected wavefront. The intermediate-layer 57 has a thickness that, in any location of the film, is 0.4 nm to 1.2 nm thinner than the corresponding depth of material actually removed from the multilayer film 56. The Ru capping layer 58 is deposited at substantially uniform thickness on the surface of the intermediate-layer 57.

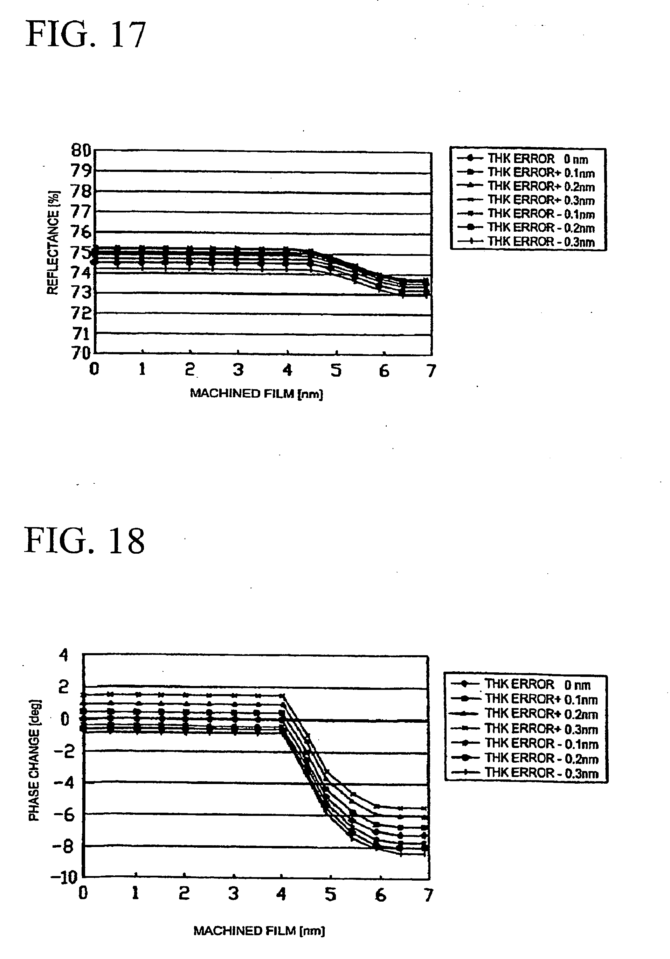

By making the film thickness of the intermediate-layer 57 in the range of 0.4 nm to 1.2 nm thinner than the removed thickness of the multilayer film 56, fluctuations in reflectance and phase change with thickness errors of the intermediate-layer 57 are reduced. FIG. 17 is a graph showing reflectance, as a function of thickness of film machined away, for the multilayer-film reflective mirror 52 of this embodiment. The reflectance changes are shown for cases in which there is no thickness error (THK ERROR of 0 nm) and in which thickness errors of ± 0.3 nm, ± 0.2 nm, and ± 0.1 nm arise during deposition of the intermediate-layer 57. FIG. 18 is a graph of phase changes for the multilayer film 52 of this embodiment. Phase changes are shown for cases in which there is no thickness error (THK ERROR of 0 nm) and in which thickness errors of ± 0.3 nm, ± 0.2 nm, and ± 0.1 nm arise during deposition of the intermediate-layer 57.

The fluctuations in reflectance and phase change shown in the graphs of FIGS. 17 and 18 reveal smaller spread compared to the graphs in FIGS. 14 and 15, pertaining to the first embodiment. That is, in FIGS. 17 and 18, the phase change caused by a thickness error in the intermediate-layer 57 of ± 0.3 nm is from -0.8° to +1.4° relative to the phase change when there is no thickness error, and the wavefront change at this time is ± 0.045 nm. Hence, the effect of a thickness error in the intermediate-layer 57 on the wavefront is approximately 1 / 14, and when the thickness of the intermediate-layer 57 is from 0.4 nm to 1.2 nm thinner than the removed thickness of the multilayer film 56 at the respective locations, fluctuations in reflectance and phase change with thickness errors are small compared with cases in which the thickness of the intermediate-layer 57 is equal to the removed thickness of the multilayer film 56.

When the thickness of the intermediate-layer 57 is made thinner by 0.4 nm than the corresponding removed thickness of the multilayer film 56, the effect on the wavefront of any thickness errors of the intermediate-layer 57 is minimized. Also, if the thickness of the intermediate-layer 57 is 1.2 nm less than the removed thickness of the multilayer film 56, the effect on reflectance fluctuations of thickness errors of the intermediate-layer 57 is minimized. Hence, if the thickness of the intermediate-layer 57 is denoted d1 (nm), and the removed thickness of the multilayer film 56 is denoted d2 (nm), the intermediate-layer 57 should be deposited so as to satisfy the condition $d2 - 0.4 \leq d1 \leq d2-1.2$.

According to the second embodiment, the thickness of the intermediate-layer is less by 0.4 nm to 1.2 nm than the removed thickness of the multilayer film. As a result, even if an error occurs in the thickness of the intermediate-layer, the changes caused thereby to reflectance and phase change of the multilayer-film reflective mirror can be minimized, and a multilayer-film reflective mirror having a highly precise surface shape can be provided.

In the multilayer-film reflective mirror of the second embodiment, the intermediate-layer is deposited 0.4 nm to 1.2 nm thinner than the thickness of multilayer film actually removed. Alternatively, the uppermost Si layer alone of the multilayer film may be deposited 0.4 nm to 1.2 nm thinner than the other Si layers in the multilayer film. Thus, the intermediate-layer may be deposited at a thickness substantially equal to the removed thickness of the multilayer film.

The multilayer film of each of the multilayer-film reflective mirrors in each of the above-described embodiments is configured from alternating layers of Mo and Si. Alternatively, configurations using materials other than Mo and Si are possible. For example, the multilayer-film reflective mirrors configured from multiple layers, each comprising a different material selected from the group consisting of Ru, Mo, Rh; and material selected from the group consisting of Si, Be (Beryllium), Boron Carbide ($B_4C$), and combinations thereof are possible. Also, a Si single-layer film is deposited as an oxidation-prevention film. Alternatively, silicon compounds such as, for example, $SiO_2$ or SiC or other materials may be deposited. Further alternatively, the intermediate layer as used in the first embodiment may also be used. In any case, it is desirable that the material actually used be one that exhibits minimal absorption of EUV light and has a refractive index near unity in the EUV wavelength range.

In the above explained embodiment, the multi-layer-film is partially removed to produce a desired in-plane distribution of the removal amount, so as to correct the reflected wavefront. Alternatively, there is disclosed that, in regions of the surface of the multilayer-film, Mo-including layer may be deposited so as to possess in-plane distribution of the thickness. Thereafter, an intermediate layer composed of Si or containing Si may be deposited so as to form an even surface thereof at the position substantially corresponding to the surface of the Si-containing layer of the multi-layer film. Thereafter, a Ru-capping layer having an even thickness may be deposited.

In the multilayer film of a multilayer-film reflective mirror according to any of the above-described embodiments, a magnetron-sputtering film-deposition device was used for film deposition. Alternatively, film deposition may be performed using any of various film-deposition devices other than a magnetron-sputtering film-deposition device. For example, an ion-beam-sputtering film-deposition device is possible.

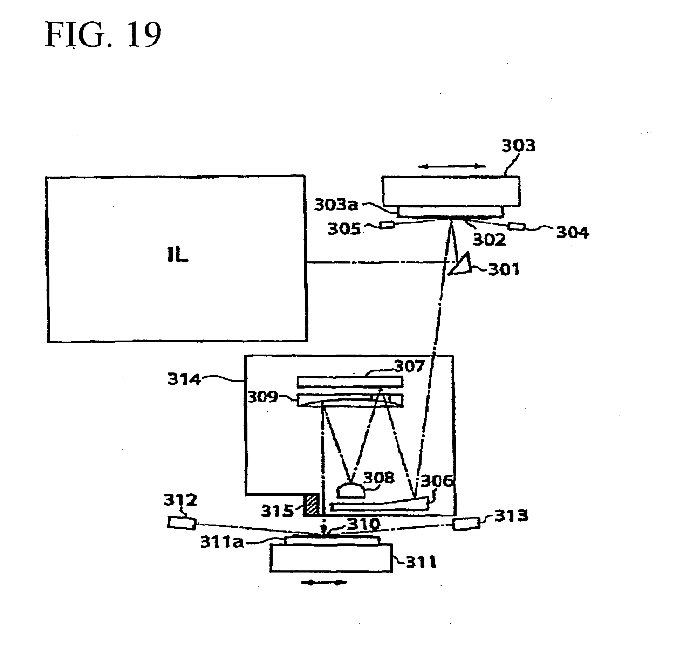

An EUV exposure system, according to a third embodiment of the invention is explained, referring to FIG. 19. The depicted EUV exposure system is a demagnifying (reducing) projection-exposure device. In the depicted system, the entire optical path is maintained in a state of high vacuum. The EUV exposure system comprises an illumination-optical system IL including an EUV light source. EUV light (in general, wavelengths from 5 to 20 nm are targeted; specifically, the 13 nm and 11 nm wavelengths are used) emitted from the illumination-optical system IL is reflected by the return mirror 301, and irradiates a reticle 302 on which a pattern is formed.

The reticle 302 is a reflection-type reticle, and is held by a chuck 303a fixed to a reticle stage 303. The reticle stage 303 is configured to perform movements of 100 mm or more in the scanning direction, and is configured to perform minute movements in a direction perpendicular to the scanning direction and in the optical-axis direction. The position of the reticle stage 303 in the scanning direction and in the direction perpendicular to the scanning direction is precisely controlled using a laser interferometer (not shown). The position in the optical-axis direction is controlled using a reticle-focus sensor, which comprises a reticle-focus optical transmitting system 304 and a reticle-focus optical receiving system 305.

In the reticle 302, a multilayer film (for example, Mo/Si or Mo/Be), which reflects EUV light, is deposited. An absorption layer (e.g., nickel (Ni) and aluminum (Al)) on this multilayer film is patterned. EUV light reflected by the reticle 302 is incident in the optical lens-barrel 314.

In the optical lens-barrel 314 are positioned multiple (four in this embodiment) mirrors 306, 307, 308, 309. At least one of these mirrors 306-309 comprises a multilayer-film reflective mirror of the first or second embodiment, or a multilayer-film reflective mirror manufactured using the method of the first embodiment. In the FIG. 19 embodiment, the projection-optical system comprises four mirrors; alternatively, six or eight mirrors may be used in the projection-optical system, in which event the numerical aperture (NA) of the projection-optical system can be made larger.

EUV light entering optical lens-barrel 314 is reflected by the mirror 306, and then reflected in succession by the mirrors 307, 308, 309. The EUV light exits the optical lens-barrel 314 and is incident on the wafer 310. The demagnification (reduction) ratio of the projection-optical system is, for example, 1/4 or 1/5. In the vicinity of the optical lens-barrel 314 is placed an off-axis microscope 315 used for performing alignment of the wafer 310.

The wafer 310 is held by a chuck 311 a fixed to a wafer stage 311. The wafer stage 311 is positioned in a plane perpendicular to the optical axis, and is configured to enable motion over, for example, 300 to 400 mm in the plane perpendicular to the optical axis. The wafer stage 311 is also configured to perform minute movements in the optical-axis direction. The position of the wafer stage 311 in the optical-axis direction is controlled by a wafer auto-focus sensor comprising a wafer auto-focus optical-transmitting system 312 and a wafer auto-focus optical-receiving system 313. The position of the wafer stage 311 in a plane perpendicular to the optical axis is controlled precisely using a laser interferometer (not shown).

At the time of exposure, the reticle stage 303 and wafer stage 311 are scanningly moved synchronously at respective velocities of which a ratio is equal to the demagnification ratio of the projection-optical system. An example is (movement velocity of reticle stage 303): (movement velocity of wafer stage 311) = 4:1 or 5:1.

According to the EUV exposure system of this third embodiment, at least one of the mirrors of the projection-optical system comprises a multilayer-film reflective mirror of the first or second embodiment or a multilayer-film reflective mirror manufactured by the manufacturing method of the first embodiment. Consequently, satisfactory exposures can be performed using an optical system comprising mirrors having precise surface shapes.

In the third embodiment, at least one of the mirrors 306-309 comprises a multilayer-film reflective mirror of the first or second embodiment, or comprises a multilayer-film reflective mirror manufactured using the method of the first embodiment. However, any of the mirrors of the illumination-optical system IL, the return mirror 301, the reticle 302, and the like may comprise a multilayer-film reflective mirror of the first or second embodiment, or may comprise a multilayer-film reflective mirror manufactured using the method of the first embodiment.

In the above explained embodiments, exposure system using EUV light is used. However, multilayer-film reflective mirror 2 shown in FIG. 1 can be provided in projection-exposure devices in which ultraviolet light other than EUV light is used as the exposure light. Even in these cases, the advantageous effects of the multilayer-film reflective mirror 2 in reducing reflectance and phase change still functions.

A multilayer-film reflective mirror 2 as shown in FIG. 1 can be used, not only in exposure systems but also in various optical systems including soft-X-ray optical systems, e.g. soft-X-ray microscope, soft-X-ray analyzer.

The EUV exposure system of the above-explained embodiment can fabricate micro devices, e.g., semiconductor devices, image sensors, liquid crystal display device, thin film magnetic head, by exposing a printing pattern generated by a reticle (mask) using a projection-optical system, on photosensitive substrate (wafer).

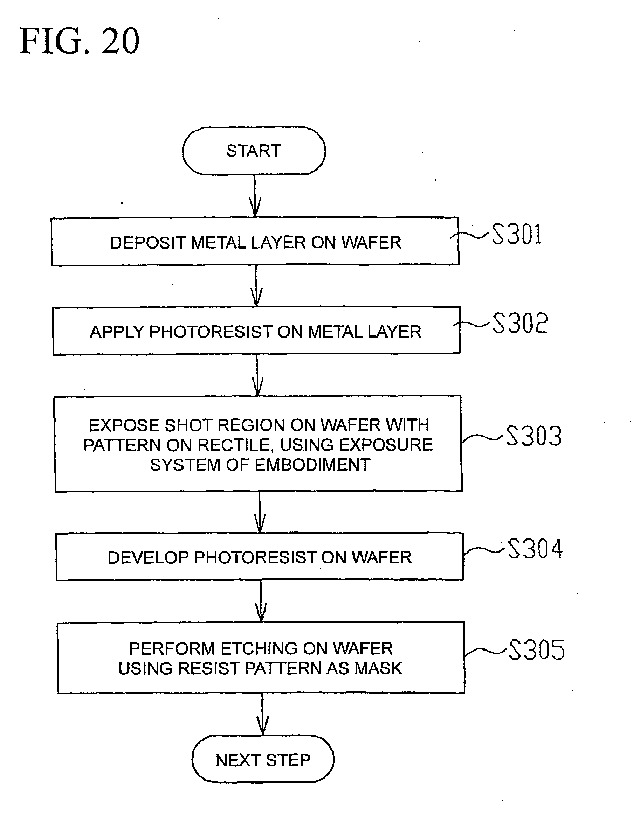

With reference to the flow chart of FIG. 20, an example of method fabricating a semiconductor device as a micro device is explained, by the method generating predetermined circuit pattern on a wafer or the like as a photosensitive substrate, using an EUV exposure system according to the above-explained embodiments.

In step S301 of the FIG. 20, metal film is deposited on one lot of wafer. In the next step (step S302), photoresist material is applied on the metal film of the lot of wafer. Thereafter, in step S303, pattern image of the mask is sequentially exposed, through the projection-optical system, in each of the shot regions on the lot of wafer. Thereafter, in step S304, the photoresist on the lot of wafer is developed. Thereafter, in step S305, an etching step is performed on the lot of wafer using the photoresist pattern as a mask, to generate a circuit pattern corresponding to the mask pattern, in each shot region on the wafer.

Thereafter, circuit patterns on upper layers are further generated. Thereafter, the resulting wafer is diced into a plurality of diced devices, to produce semiconductor devices and the like. According to the semiconductor device manufacturing method described above, since the exposure is performed using the exposure device of above-explained embodiment, circuit patterns corresponding to each layer is exposed accurately, and high quality semiconductor devices can be obtained.

In steps S301 to S305, metal is deposited on the wafer, and then the photoresist is applied on the metal film. Thereafter, the steps of exposure, development, and etching are performed. However, prior to those steps, silicon oxide film may be produced on the wafer, and then the photoresist may be applied on the silicon oxide film. Thereafter, the steps of exposure, development, and etching may be performed.

According to the multilayer-film reflective mirror of the present invention, an intermediate layer is deposited on the multilayer film which is partially machined in the vicinity of the surface thereof. The thickness of the intermediate layer corresponds to the machined amount of the multilayer, and the surface of the intermediate layer is flattened. Therefore, even when a capping layer is evenly deposited on the surface of the intermediate layer, the phase and reflectance change of the multilayer-film reflective mirror caused by the machined amount thereof, can be avoided. Therefore, the multilayer-film reflective mirror having high-precision surface profile can be provided.

The manufacturing method of multilayer-film reflective mirror of the present invention includes a step of depositing an intermediate layer on the multilayer film which is partially machined in the vicinity of the surface thereof. The intermediate layer depositing step forms the intermediate layer so that the thickness thereof corresponds to the machined amount of the multilayer, and the surface thereof is flattened. The manufacturing method of multilayer-film reflective mirror of the present invention further includes a step of evenly depositing capping layer on the surface of the intermediate layer. Therefore, the phase and reflectance change of the multilayer-film reflective mirror caused by the machined amount thereof, can be avoided. Therefore, the multilayer-film reflective mirror having high-precision surface profile can be provided.

According to the exposure device of the present invention, since at least part of the optical system thereof is provided with a multilayer-film reflective mirror having high-precision surface profile, it is possible to perform a high-precision exposure.

According to the device manufacturing method of the present invention, since the device is manufactured using the exposure device of the present invention, high-quality device can be manufactured.

<Example 1>

As shown in FIG. 1, Mo/Si multilayer film 6 including fifty layer-pairs was formed. Each Mo layer had a thickness of 2.415 nm, each Si layer had a thickness of 4.485 nm, and the period length was 6.9 nm. After layer-machining the surface of the multilayer film 6, an intermediate-layer 7 was applied to re-fill the machined areas. Thereafter, the surface of the intermediate-layer 7 was planarized. Thereafter, atop the Si single-layer film 7 was formed a Ru capping layer 8 having a uniform film thickness of 2 nm. The target reference height to which the Si single-layer film 7 was formed was the height of the topmost surface of the Mo/Si multilayer film 6 prior to layer-machining.

In example 1, the changes in phase and reflectance, as functions of layer-machining amount, are shown in FIG. 12, showing that precise wavefront control is achievable. The Ru capping layer ensures a durable multilayer-film reflective mirror that is resistant to contamination and oxidation.

<Example 2>

As shown in FIG. 13, a Mo/Si multilayer film 6 including 50 layer-pairs was formed. Each Mo layer had a thickness of 2.415 nm, each Si layer had a thickness of 4.485 nm, and the period length was 6.9 nm. After layer-machining the surface of the multilayer film 6, a Si single-layer film (intermediate-layer 7) was formed for re-filling the machined areas, and the surface thereof was re-planarized. Atop the intermediate-layer 7 was formed a Ru capping layer 8 having a uniform film thickness of 2 nm. However, thickness errors were introduced in the course of forming the Si single-layer film 7. Also, errors were introduced to the surface of the Si single-layer film 7 while machining it to a profile opposite the profile of the layer-machined multilayer film. Consequently, the profile of the surface of the Si single-layer film 7 was not completely planar, and had a thickness error of $\pm$ 0.3 nm. The target reference height to which the intermediate-layer 7 was formed was the topmost surface of the Mo/Si multilayer film 6 prior to layer-machining.

In example 2, the changes in phase and reflectance, as functions of layer-machining amount, are as shown in FIGS. 14 and 15, which show that precise wavefront control is achievable. The re-filling thickness error was $\pm$ 0.3 nm, but the resulting wavefront error was within $\pm$ 0.09 nm. Thus, the effect of the re-filling error was held to a small amount. The Ru capping layer ensured a durable multilayer-film reflective mirror that is resistant to contamination and oxidation.

<Example 3>

As shown in FIG. 16, a Mo/Si multilayer film 56 was formed. The multilayer film 56 had 50 layer-pairs, in which each Mo layer had a thickness of 2.415 nm, each Si layer had a thickness of 4.485 nm, and the period length was 6.9 nm. After layer-machining the surface of the multilayer-film, an Si single-layer film 57 was applied to re-fill the machined areas. The Si single-layer film 57 was planarized, and a Ru capping layer of uniform thickness was formed atop the Si single-layer film 57. The Si single-layer film 57 was deposited so as to have a thickness 0.8 nm thinner than the removal thickness of the multilayer film 56. Thickness errors were introduced during re-filling with the Si single-layer film 57, and machining errors were introduced when machining the Si single-layer film 57 to have a profile opposite the layer-machined profile of the multilayer-film. Consequently, the surface of the Si single-layer film 57 was not completely planar, and had a thickness error of $\pm$ 0.3 nm. The target reference height to which the Si single-layer film 57 was formed was 0.8 nm lower than the height of the uppermost layer of the Mo/Si multilayer film 56 prior to layer-machining.

According to Example 3, the changes in phase and reflectance, as functions of layer-machining amount, are as shown in FIGS. 17 and 18, which show that precise wavefront control is achievable. The re-filling thickness error was $\pm$ 0.3 nm, but the resulting wavefront error was within $\pm$ 0.09 nm. Consequently, the effect of the re-filling error was held to a small amount. The Ru capping layer ensured a durable multilayer-film reflective mirror that is resistant to contamination and oxidation.

The present disclosure relates to the subjects included in Japanese Patent Application No. 2005-295856, filed October 11, 2005.

INDUSTRIAL APPLICABILITY

As disclosed above, the multilayer-film mirrors, the methods for manufacturing the multilayer-film mirrors, the exposure systems including the multilayer-film mirrors, and the methods for manufacturing the devices including the exposure systems, will contribute to the manufacture of microdevices such as high-performance semiconductor device, thin film magnetic head, and the like.

**Claims**

1. A multilayer-film reflective mirror (2), comprising:

> a mirror substrate (4);
> a multilayer film (6) provided on a surface of the mirror substrate (4), having alternating layers of a first material (6a) and a second material (6b) ; wherein
> at least one of the layers of the first material (6a) in a vicinity of a surface of the multilayer film (6) has a thickness distribution so as to correct the wavefront of light reflected from the surface, and wherein the mirror (2) comprises an intermediate-layer (7) of Si or of a material having Si provided on the surface of the multilayer film (6), **characterized in that** the intermediate-layer (7) has an even surface, **in that** the even surface of the intermediate-layer (7) is provided substantially at a position corresponding to a surface of the second material (6b) of the multilayer film (6), and **in that** the multilayer-film reflective mirror further comprises a capping layer (8) having a substantially uniform thickness, the capping layer (8) being provided on the even surface of the intermediate-layer (7).

**2.** The multilayer-film reflective mirror (2) of claim 1, wherein the multilayer film (6) is reflective to EUV light having a wavelength in a range of 11 nm to 14 nm.

**3.** The multilayer-film reflective mirror (2) of claim 1, wherein the first material (6a) comprises Mo and the second material (6b) comprises Si.

**4.** The multilayer-film reflective mirror (2) of claim 1, wherein the intermediate-layer (7) comprises a material selected from the group consisting of Si, SiO$_2$, SiC, or combinations thereof.

**5.** The multilayer-film reflective mirror (2) of claim 4, wherein the intermediate-layer (7) comprises multiple layers each comprising a different material selected from the group.

**6.** The multilayer-film reflective mirror (2) of claim 1, wherein the intermediate-layer (7) has a substantially flat surface.

**7.** The multilayer-film reflective mirror (2) of claim 1, wherein the capping layer (8) comprises a material selected from the group consisting of Ru, Ru alloys, Rh, Rh alloys, Nb, Nb alloys, Pt, Pt alloys, Mo, Mo alloys, TiO$_2$, SiO$_2$, ZrO$_2$, MoSi$_2$, and SiC, and combinations thereof.

**8.** The multilayer-film reflective mirror (2) of claim 7, wherein the capping layer (8) comprises multiple layers each comprising a different material selected from the group.

**9.** The multilayer-film reflective mirror (2) of claim 1, wherein the layer of the first material (6a) in the vicinity of the surface of the multilayer film (6) having a thickness distribution is formed by removing the multilayer film (6) in the vicinity of the surface thereof, and
wherein the thickness of the intermediate-layer (7) is substantially the same as the removal thickness of the multilayer film (6).

**10.** The multilayer-film reflective mirror (2) of claim 9, wherein, when the thickness of the intermediate-layer (7) is denoted as d1 (nm), and the thickness of the multilayer film (6) is denoted as d2 (nm), a relationship d2 - 0.4$\leq$ d1$\leq$ d2 - 1.2 is fulfilled.

**11.** A method of manufacturing a multilayer-film reflective mirror (2) comprising:

    a multilayer film formation step (S10), in which a multilayer film (6) is formed on a surface of a mirror substrate (4), so as to have alternating layers of a first material (6a) and a second material (6b);
    a capping layer (8) film formation step (S13),
    a multilayer film removal step (S12), so as to correct the wavefront of light reflected from the surface, in which a surface of the multilayer film (6) is removed, so as to have a distribution of a removal amount across the surface of the multilayer film (6);
    an intermediate-layer film formation step (S12), in which an intermediate-layer (7) of Si, or of a material including Si is formed on the surface of the multilayer film (6) in a region in which the multilayer film (6) has been removed in the multilayer film removal step (S11), so as to have a thickness substantially same as the removal thickness of the multilayer film (6) and to have an even surface, and
    wherein in the capping layer film formation step (S13) a capping layer (8) is formed on the surface of the intermediate-layer (7), so as to have a substantially uniform thickness.

**12.** The method of manufacturing multilayer-film reflective mirror (2) of claim 11, wherein the intermediate-layer film formation step (S12) comprises:

    a step (S20) in which the intermediate-layer (7) of Si, or of a material including Si is deposited, so as to have a predetermined thickness; and
    a step (S21) in which the intermediate-layer (7) is flattened so that the surface of the intermediate-layer (7) is situated substantially the same as a surface of the second material (6b).

**13.** The method of manufacturing multilayer-film reflective mirror (2) of claim 12,
wherein, when the thickness of the intermediate-layer (7) is denoted as d1 (nm), and the thickness of the multilayer film (6) is denoted as d2 (nm), a relationship d2 - 0.4$\leq$ d1$\leq$ d2 - 1.2 is fulfilled.

**14.** An optical system, comprising a multilayer-film reflective mirror (2) as recited in any one of claims 1 to 10.

**15.** An exposure system, comprising an optical system including the multilayer-film reflective mirror (2) as recited in any one of claims 1 to 10.

**16.** An exposure system, comprising an optical system including a multilayer-film reflective mirror (2) manufactured by the method as recited in any one of claims 11 to 13.

**17.** A method of manufacturing a microdevice, comprising:

    an exposure step in which an image of a pattern is exposed on an object using the exposure system as recited in any one of claims 15 or 16; and a step in which the pattern exposed in the exposure step on the object is developed.

**Patentansprüche**

1. Reflektierender Mehrschichtfilm-Spiegel (2), welcher umfasst:

ein Spiegelsubstrat (4);
einen mehrschichtigen Film (6), der auf einer Oberfläche des Spiegelsubstrats (4) vorgesehen ist, mit alternierenden Schichten eines ersten Materials (6a) und eines zweiten Materials (6b); wobei wenigstens eine der Schichten des ersten Materials (6a) in einer Nähe einer Oberfläche des mehrschichtigen Films (6) eine Dickenverteilung aufweist, um die Wellenfront von von der Oberfläche reflektiertem Licht zu korrigieren, und wobei der Spiegel (2) eine Zwischenschicht (7) aus Si oder einem Material mit Si, die auf der Oberfläche des mehrschichtigen Films (6) bereitgestellt ist, umfasst, **dadurch gekennzeichnet, dass** die Zwischenschicht (7) eine ebene Oberfläche aufweist, dass die ebene Oberfläche der Zwischenschicht (7) im wesentlichen an einer Position entsprechend einer Oberfläche des zweiten Materials (6b) des mehrschichtigen Films (6) bereitgestellt ist, und dass der reflektierende Mehrschichtfilm-Spiegel ferner eine Deckschicht (8) mit einer im wesentlichen einheitlichen Dicke umfasst, wobei die Deckschicht (8) auf der ebenen Oberfläche der Zwischenschicht (7) vorgesehen ist.

2. Reflektierender Mehrschichtfilm-Spiegel (2) nach Anspruch 1, wobei der mehrschichtige Film (6) gegenüber EUV-Licht mit einer Wellenlänge im Bereich von 11 nm bis 14 nm reflektierend ist.

3. Reflektierender Mehrschichtfilm-Spiegel (2) nach Anspruch 1, wobei das erste Material (6a) Mo umfasst und das zweite Material (6b) Si umfasst.

4. Reflektierender Mehrschichtfilm-Spiegel (2) nach Anspruch 1, wobei die Zwischenschicht (7) ein Material umfasst, das ausgewählt ist aus der Gruppe bestehend aus Si, $SiO_2$, SiC oder Kombinationen derselben.

5. Reflektierender Mehrschichtfilm-Spiegel (2) nach Anspruch 4, wobei die Zwischenschicht (7) mehrere Schichten umfasst, die jeweils ein unterschiedliches aus der Gruppe ausgewähltes Material umfassen.

6. Reflektierender Mehrschichtfilm-Spiegel (2) nach Anspruch 1, wobei die Zwischenschicht (7) eine im wesentlichen flache Oberfläche aufweist.

7. Reflektierender Mehrschichtfilm-Spiegel (2) nach Anspruch 1, wobei die Deckschicht (8) ein Material umfasst, das ausgewählt ist aus der Gruppe bestehend aus Ru, Ru-Legierungen, Rh, Rh-Legierungen, Nb, Nb-Legierungen, Pt, Pt-Legierungen, Mo, Mo-Legierungen, $TiO_2$, $SiO_2$, $ZrO_2$, $MoSi_2$ und SiC und Kombinationen derselben.

8. Reflektierender Mehrschichtfilm-Spiegel (2) nach Anspruch 7, wobei die Deckschicht (8) mehrere Schichten umfasst, die jeweils ein unterschiedliches aus der Gruppe ausgewähltes Material umfassen.

9. Reflektierender Mehrschichtfilm-Spiegel (2) nach Anspruch 1, wobei die Schicht des ersten Materials (6a) in der Nähe der Oberfläche des mehrschichtigen Films (6) mit einer Dickenverteilung gebildet ist durch Entfernen des mehrschichtigen Films (6) in der Nähe der Oberfläche derselben, und wobei die Dicke der Zwischenschicht (7) im wesentlichen die gleiche ist wie die entfernte Dicke des mehrschichtigen Films (6).

10. Reflektierender Mehrschichtfilm-Spiegel (2) nach Anspruch 9, wobei, wenn die Dicke der Zwischenschicht (7) als d1 (nm) bezeichnet wird und die Dicke des mehrschichtigen Films (6) als d2 (nm) bezeichnet wird, eine Beziehung $d2 - \underline{0{,}4} \leq d1 \leq d2 - 1{,}2$ erfüllt ist.

11. Verfahren zum Herstellen eines reflektierenden Mehrschichtfilm-Spiegels (2), welches umfasst:

einen Schritt (S10) zum Bilden eines mehrschichtigen Films, bei dem ein mehrschichtiger Film (6) auf einer Oberfläche eines Spiegelsubstrats (4) gebildet wird, um alternierende Schichten eines ersten Materials (6a) und eines zweiten Materials (6b) aufzuweisen;
einen Schritt (S 13) zum Bilden eines Deckschichtfilms (8),
einen Schritt (S 12) zum Entfernen des mehrschichtigen Films, um so die Wellenfront von Licht, das von der Oberfläche reflektiert wird, zu korrigieren, bei dem eine Oberfläche des mehrschichtigen Films (6) entfernt wird, um so eine Verteilung einer Entfernungsmenge über die Oberfläche des mehrschichtigen Films (6) zu haben;
einen Schritt (S12) zum Bilden eines Zwischenschichtfilms, bei dem eine Zwischenschicht (7) aus Si oder aus einem Si einschließenden Material auf der Oberfläche des mehrschichtigen Films (6) in einem Bereich gebildet wird, in dem der mehrschichtige Film (6) in dem Schritt (S 11) zum Entfernen des mehrschichtigen Films entfernt worden ist, um eine Dicke aufzuweisen, die im wesentlichen gleich ist wie die entfernte Dicke des mehrschichtigen Films (6) und um eine ebene Oberfläche aufzuweisen, und wobei in dem Schritt (S13) zum Bilden des Deckschichtfilms eine Deckschicht (8) auf der Oberfläche der Zwischenschicht (7) gebildet wird, um eine im wesentlichen einheitliche Dicke aufzuweisen.

**12.** Verfahren zum Herstellen eines reflektierenden Mehrschichtfilm-Spiegels (2) nach Anspruch 11, wobei der Schritt (S12) zum Bilden des Zwischenschichtfilms umfasst:

einen Schritt (S20), in dem die Zwischenschicht (7) aus Si oder aus einem Si einschließenden Material abgeschieden wird, um eine vorgegebene Dicke aufzuweisen; und einen Schritt (S21), in dem die Zwischenschicht (7) so geglättet wird, dass die Oberfläche der Zwischenschicht (7) im wesentlichen gleich wie eine Oberfläche des zweiten Materials (6b) angeordnet ist.

**13.** Verfahren zum Herstellen eines reflektierenden Mehrschichtfilm-Spiegels (2) nach Anspruch 12, wobei, wenn die Dicke der Zwischenschicht (7) als d1 (nm) bezeichnet wird und die Dicke des mehrschichtigen Films (6) als d2 (nm) bezeichnet wird, eine Beziehung d2 - 0,4 ≤ d1 ≤ d2 - 1,2 erfüllt wird.

**14.** Optisches System umfassend einen reflektierenden Mehrschichtfilm-Spiegel (2), wie er in einem der Ansprüche 1 bis 10 beschrieben wird.

**15.** Belichtungssystem umfassend ein optisches System einschließend den reflektierenden Mehrschichtfilm-Spiegel (2), wie er in einem der Ansprüche 1 bis 10 beschrieben wird.

**16.** Belichtungssystem umfassend ein optisches System einschließend einen reflektierenden Mehrschichtfilm-Spiegel (2), hergestellt durch das Verfahren, wie es in einem der Ansprüche 11 bis 13 beschrieben wird.

**17.** Verfahren zum Herstellen einer Mikrovorrichtung, umfassend:

einen Belichtungsschritt, in dem ein Abbild eines Bildes auf einem Gegenstand unter Verwendung des Belichtungssystems, wie es in einem der Ansprüche 15 oder 16 beschrieben wird, belichtet wird; und einen Schritt, in dem das in dem Belichtungsschritt auf dem Gegenstand belichtete Bild entwickelt wird.

## Revendications

**1.** Miroir réfléchissant (2) à film multicouche, comprenant :

un substrat (4) de miroir ; un film multicouche (6) disposé sur une surface du substrat (4) de miroir, ayant des couches alternées d'un premier matériau (6a) et d'un second matériau (6b) ; dans lequel au moins une des couches du premier matériau (6a) à proximité d'une surface du film multicouche (6) possède une distribution d'épaisseur de manière à corriger le front d'onde de la lumière réfléchie par la surface, et dans lequel le miroir (2) comprend une couche intermédiaire (7) de Si ou d'un matériau ayant du Si disposé à la surface du film multicouche (6), **caractérisé en ce que** la couche intermédiaire (7) possède une surface régulière, **en ce que** la surface régulière de la couche intermédiaire (7) est disposée sensiblement en une position correspondant à une surface du second matériau (6b) du film multicouche (6), et **en ce que** le miroir réfléchissant à film multicouche comprend en outre une couche (8) de recouvrement étant disposée sur la surface régulière de la couche intermédiaire (7).

**2.** Miroir réfléchissant (2) à film multicouche selon la revendication 1, dans lequel le film multicouche (6) réfléchit la lumière EUV ayant une longueur d'onde dans une fourchette comprise entre 11 et 14 nm.

**3.** Miroir réfléchissant (2) à film multicouche selon la revendication 1, dans lequel le premier matériau (6a) comprend du Mo, et le second matériau (6b) comprend du Si.

**4.** Miroir réfléchissant (2) à film multicouche selon la revendication 1, dans lequel la couche intermédiaire (7) comprend un matériau sélectionné parmi le groupe composé de Si, $SiO_2$, SiC ou des combinaisons de ceux-ci.

**5.** Miroir réfléchissant (2) à film multicouche selon la revendication 4, dans lequel la couche intermédiaire (7) comprend plusieurs couches comprenant chacune un matériau différent sélectionné parmi le groupe.

**6.** Miroir réfléchissant (2) à film multicouche selon la revendication 1, dans lequel la couche intermédiaire (7) possède une surface sensiblement plate.

**7.** Miroir réfléchissant (2) à film multicouche selon la revendication 1, dans lequel la couche (8) de recouvrement comprend un matériau sélectionné parmi le groupe composé de Ru, alliages de Ru, Rh, alliages de Rh, Nb, alliages de Nb, Pt, alliages de Pt, Mo, alliages de Mo, $TiO_2$, $SiO_2$, $ZrO_2$, $MoSi_2$, SiC et de combinaisons de ceux-ci.

8. Miroir réfléchissant (2) à film multicouche selon la revendication 7, dans lequel la couche (8) de recouvrement comprend plusieurs couches comprenant chacune un matériau différent sélectionné parmi le groupe.

9. Miroir réfléchissant (2) à film multicouche selon la revendication 1,
   dans lequel la couche du premier matériau (6a) à proximité de la surface du film multicouche (6) ayant une distribution d'épaisseur est formée en retirant le film multicouche (6) à proximité de la surface de celui-ci, et
   dans lequel l'épaisseur de la couche intermédiaire (7) est sensiblement la même que l'épaisseur de retrait du film multicouche (6).

10. Miroir réfléchissant (2) à film multicouche selon la revendication 9,
   dans lequel, lorsque l'épaisseur de la couche intermédiaire (7) est appelée d1 (nm), et l'épaisseur du film multicouche (6) est appelé d2 (nm), une relation $d2 - 0,4 \leq d1 \leq d2 - 1,2$ est atteinte.

11. Procédé de fabrication d'un miroir réfléchissant (2) à film multicouche comprenant :

   une étape (S10) de formation de film multicouche, dans laquelle un film multicouche (6) est formé sur une surface d'un substrat (4) de miroir, de manière à avoir des couches alternées d'un premier matériau (6a) et d'un second matériau (6b) ;
   une étape (S13) de formation de film à couche (8) de recouvrement,
   une étape (S12) de retrait de film multicouche, de manière à corriger le front d'onde de la lumière réfléchie par la surface, dans laquelle une surface du film multicouche (6) est retirée, de manière à avoir une distribution d'une quantité de retrait à travers la surface du film multicouche (6) ;
   une étape (S12) de formation de film à couche intermédiaire, dans laquelle une couche intermédiaire (7) de Si, ou d'un matériau comprenant du Si, est formée à la surface du film multicouche (6) dans une région dans laquelle le film multicouche (6) a été retiré lors de l'étape (S11) de retrait de film multicouche, de manière à avoir une épaisseur sensiblement égale à l'épaisseur de retrait du film multicouche (6) et à avoir une surface régulière, et

dans lequel, lors de l'étape (S13) de formation de film à couche de recouvrement, une couche (8) de recouvrement est formée à la surface de la couche intermédiaire (7), de manière à avoir une épaisseur sensiblement uniforme.

12. Procédé de fabrication d'un miroir réfléchissant (2) à film multicouche selon la revendication 11, dans lequel l'étape (S12) de formation de film à couche intermédiaire comprend :

   une étape (S20) dans laquelle la couche intermédiaire (7) de Si, ou d'un matériau comprenant du Si est déposée, de manière à avoir une épaisseur prédéterminée ; et
   une étape (S21) dans laquelle la couche intermédiaire (7) est aplatie de sorte que la surface de la couche intermédiaire (7) est située sensiblement au même niveau que la surface du second matériau (6b).

13. Procédé de fabrication d'un miroir réfléchissant (2) à film multicouche selon la revendication 12,
   dans lequel, lorsque l'épaisseur de la couche intermédiaire (7) est appelée d1 (nm), et l'épaisseur du film multicouche (6) est appelé d2 (nm), une relation $d2 - 0,4 \leq d1 \leq d2 - 1,2$ est atteinte.

14. Système optique, comprenant un miroir réfléchissant (2) à film multicouche selon l'une des revendications 1 à 10.

15. Système d'exposition, comprenant un système optique comportant le miroir réfléchissant (2) à film multicouche selon l'une des revendications 1 à 10.

16. Système d'exposition, comprenant un système optique comportant un miroir réfléchissant (2) à film multicouche fabriqué d'après le procédé selon l'une des revendications 11 à 13.

17. Procédé de fabrication d'un micro-dispositif, comprenant :

   une étape d'exposition dans laquelle une image d'un modèle est exposée sur un objet à l'aide du système d'exposition selon l'une des revendications 15 ou 16 ; et
   une étape lors de laquelle le modèle exposé sur l'objet lors de l'étape d'exposition est développé.

FIG. 1

FIG. 2

## FIG. 3

## FIG. 4

FIG. 5

A

B

d

FIG. 6

6a

6b

6

4

# FIG. 7

MACHINED FILM [nm]

# FIG. 8

START

DEPOSIT INTERMEDIATE LAYER
OF PRESCRIBED THICKNESS ~ S20

FLATTEN SURFACE OF LAYER ~ S21

END

## FIG. 9

## FIG. 10

# FIG. 11

# FIG. 12

## FIG. 13

## FIG. 14

# FIG. 15

# FIG. 16

## FIG. 17

## FIG. 18

# FIG. 19

# FIG. 20

START

DEPOSIT METAL LAYER ON WAFER ~S301

APPLY PHOTORESIST ON METAL LAYER ~S302

EXPOSE SHOT REGION ON WAFER WITH PATTERN ON RECTILE, USING EXPOSURE SYSTEM OF EMBODIMENT ~S303

DEVELOP PHOTORESIST ON WAFER ~S304

PERFORM ETCHING ON WAFER USING RESIST PATTERN AS MASK ~S305

NEXT STEP

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003014893 A
- US 20020084425 A
- US 20030147139 A1
- WO 0141155 A
- WO 014115 A
- JP 2005295856 A